# EUROPEAN PATENT APPLICATION

(11) **EP 4 317 993 A1**
(43) Date of publication of application: **07.02.2024**
(21) Application number: 22780527.2
(22) Date of filing: 25.03.2022
(51) Int. Cl.: G01R 15/24, G01R 19/00

(54) **CURRENT MEASUREMENT DEVICE**

(30) Priority: 30.03.2021 JP 2021056363
(71) Applicant: Orbray Co., Ltd., Tokyo 123-8511 (JP)
(72) Inventor: SASAKI Masaru, Tokyo 123-8511 (JP)
(74) Representative: Dennemeyer & Associates S.A.
(86) International application number: PCT/JP2022/014202
(87) International publication number: WO 2022/210313

(57) **Abstract**

The current measuring device includes a sensing optical fiber, a light source, two photo-variable attenuators, and a signal processing circuit including two photoelectric conversion elements. The signal processing circuit further includes two photoelectric conversion element and a current-voltage conversion circuit. The two photoelectric conversion elements are connected in series. Optical signals enter the photo-variable attenuators and then enter the two photoelectric conversion elements for conversion to a first photocurrent and a second photocurrent. The respective photocurrents are fed back to the respective photo-variable attenuators to adjust a quantity of light entering the two photoelectric conversion elements and keep the DC components in the respective photocurrents equal to each other. Simultaneously, a difference between the respective photocurrents is inputted to the current-voltage conversion circuit for offsetting of the DC components in the respective photocurrents. A difference between AC components is outputted to convert the current to be measured that passes through the conductor, to a current signal for measurement.

## Description

### TECHNICAL FIELD

The present invention relates to a current measuring device.

### BACKGROUND ART

Current measuring devices utilizing the Faraday effect in optical fibers include, for example, Patent Literature 1.

In the current measuring device in Patent Literature 1, an optical fiber is disposed around a current-carrying conductor. This optical fiber converts laser light from a semiconductor laser light source into linearly polarized light for propagation. The polarization angle is varied by current passing through the current-carrying conductor at the polarization plane of the linearly polarized light. Subsequently, the light emitted from the optical fiber is split into P waves and S waves, which are converted into voltage signals by two photodiodes. A splitter of an arithmetic processing unit further splits alternate current components and direct current components. First and second component ratios of the alternate current components and the direct current components are determined by two dividers, respectively, and the difference therebetween is calculated by a computing unit. Finally, based on an output of the computing unit, the value of the current passing through the current-carrying conductor is measured.

Current measuring devices are also used for evaluation and inspection of power semiconductors that control and supply power (electric power).

### CITATION LIST

### PATENT LITERATURE

PATENT LITERATURE 1: Japanese Patent No. 3342768

### SUMMARY OF INVENTION

### PROBLEMS TO BE SOLVED BY INVENTION

In the case that the divider is used as in the current measuring device described in Patent Literature 1, measurement of the current with a high frequency (several M(Hz) to several hundred M(Hz)) is difficult due to band limitations to the divider.

Enhancement of performance of the power semiconductors is also accompanied by request for measurement of the current of devices operating at higher switching frequencies.

The present invention has been made in view of the above-described problem. An object of the present invention is to provide the below-described type of current measuring device. Specifically, such a current measuring device can achieve measurement of current with high frequency by using no divider in the current measuring device and can measure the current of devices operating at higher switching frequency.

### SOLUTION TO PROBLEMS

The aforementioned problem is solved by the present invention hereinbelow described. Specifically, a current measuring device according to the present inventions includes at least: a sensing optical fiber; a light source; two photo-variable attenuators; and a signal processing circuit including two photoelectric conversion elements, in which: the sensing optical fiber is, for placement, wound around an outer periphery of a conductor through which a current to be measured passes; optical signals emitted from the light source are propagated in the sensing optical fiber, and a Faraday effect caused by the optical signals propagated in the sensing optical fiber rotates polarization planes of the optical signals for measurement of the current to be measured that passes through the conductor; the signal processing circuit further includes at least two photoelectric conversion elements and a current-voltage conversion circuit; the two photoelectric conversion elements are connected in series; the optical signals enter the photo-variable attenuators and then enter the two photoelectric conversion elements for conversion to a first photocurrent and a second photocurrent; the first photocurrent or the second photocurrent is fed back to respective photo-variable attenuators to adjust a quantity of light entering the two photoelectric conversion elements and keep DC components in the first photocurrent and the second photocurrent equal to each other; and a difference between the first photocurrent and the second photocurrent is inputted to the current-voltage conversion circuit for offsetting of the DC components in the first photocurrent and the second photocurrent, and a difference between AC components are outputted to convert the current to be measured that passes through the conductor, to a current signal for measurement.

In other words, the current measuring device according to the present invention has a configuration with no divider.

### EFFECTS OF INVENTION

The current measuring device according to the present invention keeps the DC components in the photocurrents at the two photoelectric conversion elements equal and inputs, to the current-voltage conversion circuit, the difference between the first photocurrent and the second photocurrent at the two photoelectric conversion elements. Thus, no divider is needed in the signal processing circuit. Furthermore, removal of in-phase noise (light source noise simultaneously entering the two photoelectric conversion elements) and output from the current measuring device can be simultaneously achieved.

Furthermore, by offsetting the DC components and inputting only the AC components to the current-voltage conversion circuit, an amplification factor of the current-voltage conversion circuit can be increased. Thus, in association with an increase in the amplification factor of the current-voltage conversion circuit, the manufacturing costs can be reduced by reducing the number of amplifiers and the number of components of the signal processing circuit.

Furthermore, band limitations to dividers are removed by using no divider, and thus the band for measurement of the current depends on performance of the current-voltage conversion circuit. This enables measurement of the current at a high frequency band (several M(Hz) to several hundred M(Hz)).

Furthermore, the current of devices operating at higher switching frequency can be measured.

### BRIEF DESCRIPTION OF DRAWINGS

Fig. 1 is an explanatory diagram illustrating a configuration of a current measuring device according to an embodiment of the present invention.
Fig. 2 is an explanatory diagram illustrating a configuration of a signal processing circuit in Fig. 1 and a state of connection between respective elements in detail.
Fig. 3 is a waveform chart of results of output according to the example of the present invention.

### DESCRIPTION OF EMBODIMENTS

A first aspect of the present embodiment is that a current measuring device is the following type of current measuring device. Such a current measuring device includes at least: a sensing optical fiber; a light source; two photo-variable attenuators; and a signal processing circuit including two photoelectric conversion elements, in which: the sensing optical fiber is, for placement, wound around an outer periphery of a conductor through which a current to be measured passes; optical signals emitted from the light source are propagated in the sensing optical fiber, and a Faraday effect caused by the optical signals propagated in the sensing optical fiber rotates polarization planes of the optical signals for measurement of the current to be measured that passes through the conductor; the signal processing circuit further includes at least two photoelectric conversion elements and a current-voltage conversion circuit; the two photoelectric conversion elements are connected in series; the optical signals enter the photo-variable attenuators and then enter the two photoelectric conversion elements for conversion to a first photocurrent and a second photocurrent; the first photocurrent or the second photocurrent is fed back to respective photo-variable attenuators to adjust a quantity of light entering the two photoelectric conversion elements and keep DC components in the first photocurrent and the second photocurrent equal to each other; and a difference between the first photocurrent and the second photocurrent is inputted to the current-voltage conversion circuit for offsetting of the DC components in the first photocurrent and the second photocurrent, and a difference between AC components are outputted to convert the current to be measured that passes through the conductor, to a current signal for measurement.

The current measuring device according to the present embodiment has a configuration with no divider.

In the foregoing configuration, the DC components in the photocurrents at the two photoelectric conversion elements are kept equal, and the difference between the photocurrents at the two photoelectric conversion elements is inputted to the current-voltage conversion circuit. Thus, no divider is needed in the signal processing circuit. Furthermore, removal of in-phase noise (light source noise simultaneously entering the two photoelectric conversion elements) and output from the current measuring device can be simultaneously achieved.

Furthermore, by offsetting the DC components and inputting only the AC components to the current-voltage conversion circuit, an amplification factor of the current-voltage conversion circuit can be increased. Thus, in association with an increase in the amplification factor of the current-voltage conversion circuit, the manufacturing costs can be reduced by reducing the number of amplifiers and the number of components of the signal processing circuit.

Furthermore, band limitations to dividers are removed by using no divider, and thus the band for measurement of the current depends on performance of the current-voltage conversion circuit. This enables measurement of the current at a high frequency band (several M(Hz) to several hundred M(Hz)).

A second aspect is a current measuring device with one current-voltage conversion circuit.

Since this configuration can limit the number of the current-voltage conversion circuits to one, the impact of the difference in individual current-voltage conversion circuits is removed.

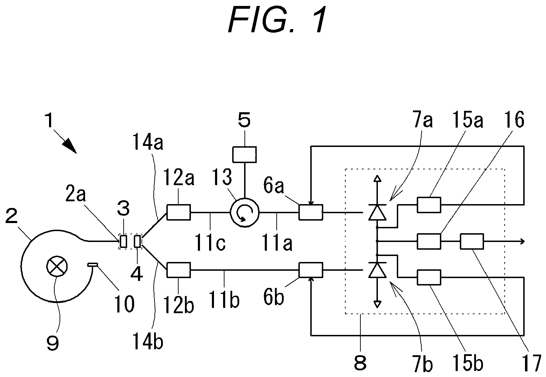

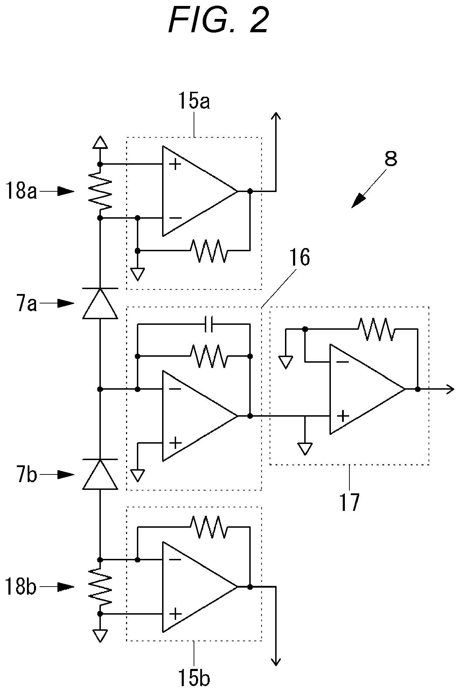

The current measuring device according to the embodiment of the present invention will be described below with reference to Figs. 1 and 2. A current measuring device 1 illustrated in Fig. 1 is configured to include at least respective components: a sensing optical fiber 2, a Faraday rotator 3, a polarization splitter 4, a light source 5, two photo-variable attenuators (6a and 6b), and a signal processing circuit 8. The current measuring device 1 further includes optical fibers (11a to 11c, 14a, and 14b) for propagating optical signals between the respective components, and an optical circulator 13 for propagating the optical signal to a predetermined optical fiber.

The signal processing circuit 8 includes photoelectric conversion elements (7a and 7b). As in Fig. 1, the signal processing circuit 8, the photo-variable attenuators (6a and 6b), the polarization splitter 4, the Faraday rotator 3, and the sensing optical fiber 2 are disposed in sequence.

The light source 5 includes a laser diode (LD), a light emitting diode (LED), a superluminescent diode (SLD), or an ASE light source. The light source 5 emits an optical signal with a predetermined wavelength λ for propagation to the optical circulator 13 through an optical fiber.

The optical circulator 13 may be of a polarization-dependent type or a polarization-independent type. The optical circulator 13 allows the optical signal emitted from the light source 5 to enter the optical fiber 11c. The optical circulator 13 may include a birefringent element, a Faraday rotator having a ration angle of 45°, a waveplate and the like that are not shown. Instead of the optical circulator 13, an optical fiber coupler may be used.

The optical signal entering the optical fiber 11c propagates to the optical fiber 14a via an optical connector 12a and enters the polarization splitter 4. The polarization splitter 4 includes a light transmissive type of uniaxial monocrystalline birefringent element. The birefringent element can be selected from rutile (TiO₂), calcite (CaCO₃), crystal (SiO₂), yttrium vanadate (YVO₄), alpha-barium borate (αBaB₂O₄), lithium niobate (LiNbO₃) and the like. The birefringent element selected from such a material is processed into a flat plate having a predetermined thickness and opposing parallel optical faces for optical entry and emission, and constitutes the polarization splitter 4. One of the parallel optical faces opposes the Faraday rotator 3 and the other one of the optical faces opposes the optical fibers (14a and 14b).

Entry of an optical signal from the optical fiber 14a into such a polarization splitter 4 splits the optical signal into two polarization components: an ordinary ray orthogonal to a crystal axis, which is not shown, of the birefringent element; and an extraordinary ray parallel to the crystal axis of the birefringent element. Only the extraordinary ray is shifted into a predetermined splitting width and deviated according to the thickness of the birefringent element so as not to enter the Faraday rotator. Only the linearly polarized light as the ordinary ray is propagated to the Faraday rotator 3.

The Faraday rotator 3 is a light transmissive type of non-reciprocal element that rotates a polarization plane and is provided with a permanent magnet around its outer periphery. The Faraday rotator 3 is formed of bismuth-substituted garnet monocrystal, TBIG, GBIG, or the like and has a desired rotation angle at the wavelength band for use (for example, 22.5°). In Fig. 1, illustration of the permanent magnet is omitted. The Faraday rotator 3 is disposed at a first end 2a, which is an end for entry and emission, of the sensing optical fiber 2.

The Faraday rotator 3 is processed into a flat plate in outer shape having a predetermined thickness and opposing parallel optical faces for optical entry and emission. Transmission of the polarization component of the ordinary ray split by the polarization splitter 4 through the Faraday rotator 3 rotates the direction of polarization by an angle of the Faraday rotation (for example, 22.5°). The linearly polarized light as the ordinary ray, which have transmitted through the Faraday rotator 3, enters the sensing optical fiber 2 from the first end 2a.

The sensing optical fiber 2 is wound around an outer periphery of a conductor 9 through which a current to be measured passes, by a desired number of times for placement. The sensing optical fiber 2 further includes the first end 2a for allowing the linearly polarized light propagating from the Faraday rotator 3 to enter and a second end for reflecting the linearly polarized light thus entered. The second end is provided with a mirror 10 as a reflecting component. At the second end, any other reflecting component than the mirror 10 can be adopted. For example, a reflective film of metal with low absorbance and high reflectance relative to light, such as gold (Au), silver (Ag), copper (Cu), chromium (Cr), aluminum (Al), and the like or a dielectric multilayered film may be provided.

According to the level of the current to be measured that passes through the conductor 9, the Faraday effect occurs to the optical signal (linearly polarized light) propagating through the sensing optical fiber 2. The Faraday effect rotates the polarization plane of the optical signal propagating in the sensing optical fiber 2. This is further reflected by the mirror 10, and the polarization plane is Faraday rotated over the reciprocating optical propagation channel. This reenters the Faraday rotator 3 from the first end 2a.

When this is reciprocatingly propagated in the sensing optical fiber 2 due to reflection by the mirror 10, the Faraday effect in the sensing optical fiber 2 rotates the linearly polarized light by α degree according to the level of the current to be measured.

The type of the optical fiber constituting the sensing optical fiber 2 is not specifically limited. Single mode optical fibers (single mode fiber: SMF), such as lead glass fiber and quartz glass fiber, capable of propagating the linearly polarized light are most suitable. In particular, the lead glass fiber is preferred because it has properties of a low photoelastic coefficient and a relatively high Verdet constant that determines the level of the Faraday effect.

The linearly polarized light, which has reentered the Faraday rotator 3 from the first end 2a, is further rotated by an angle of the Faraday rotation of the Faraday rotator 3 when transmitting through the Faraday rotator 3. Thus, in the initial transmission through the Faraday rotator 3, the linearly polarized light transmitting as the ordinary ray reciprocatingly transmits through the Faraday rotator 3, which rotates the polarization plane by 45° in total (in the case of an angle of the Faraday rotation of 22.5°). The linearly polarized light then reenters the polarization splitter 4.

In the case that the current to be measured does not pass through the conductor 9, the angle of the Faraday rotation occurring to the linearly polarized light reciprocatingly transmitting through the Faraday rotator 3 is 45° in total. Meanwhile, in the case that the current to be measured is passing through the conductor 9, the angle of the Faraday rotation occurring to the linearly polarized light reciprocatingly transmitting through the Faraday rotator 3 is (45 + α) degrees in total.

The linearly polarized light reentering the polarization splitter 4 is split into two polarization components: an ordinary ray orthogonal to a crystal axis, which is not shown, of the birefringent element; and an extraordinary ray parallel to the crystal axis of the birefringent element. Only the linearly polarized light as the extraordinary ray parallel to the crystal axis is shifted and two types of linearly polarized light enter the optical fibers 14a or 14b, respectively.

In the case that the current to be measured passes through the conductor 9, the angle of the Faraday rotation occurring to the linearly polarized light reciprocatingly transmitting through the Faraday rotator 3 is (45 + α) degrees in total. This causes an imbalance in the ratio of intensity when the ordinary ray and the extraordinary ray are split.

Reflection of the optical signal emitted from the light source 5 by the mirror 10 at the second end of the sensing optical fiber 2 determines a reciprocating optical channel for reciprocating the polarization splitter 4, the Faraday rotator 3, and the sensing optical fiber 2.

The linearly polarized light entering the optical fibers 14a or 14b, respectively, further propagates into the optical fibers 11c or 1 1b via the optical connectors 12a or 12b. The optical signal propagating in the optical fiber 11c is propagated by the optical circulator 13 from the optical fiber 11c to the optical fiber 11a.

For the optical fibers (11a, 11b, 11c, 14a, and 14b) and the optical fiber disposed between the light source 5 and the optical circulator 13, SMFs or polarization plane maintaining fibers (so-called polarization maintaining fibers: PMFs) may be used.

The optical signals propagating in the optical fiber 11a or 11b enter photo-variable attenuators 6a or 6b, respectively. The photo-variable attenuators 6a or 6b are photo-variable attenuators driven by electric signals and are optically connected to the optical fibers 11a or 11b, respectively.

The light outputted from the photo-variable attenuators 6a or 6b further enters the two photoelectric conversion elements 7a or 7b provided in the signal processing circuit 8. The two photoelectric conversion elements 7a or 7b convert the incident optical signals to a first photocurrent and a second photocurrent, respectively.

According to the level of the optical signals entering from the photo-variable attenuators 6a or 6b, the two photoelectric conversion elements 7a or 7b convert the optical signals to the first photocurrent and the second photocurrent. These first photocurrent and the second photocurrent are fed back to the photo-variable attenuators 6a or 6b, respectively, to adjust a quantity of the optical signals entering the two photoelectric conversion elements 7a or 7b.

In a state where no feedback signal is inputted, the photo-variable attenuator 6a or 6b allows the inputted optical signal as-is to enter the photoelectric conversion element 7a or 7b. In the case that the light quantity of the optical signal entering from the photoelectric conversion element 7a or 7b is insufficient, attenuation of the photo-variable attenuator 6a or 6b is 0 (zero), and the DC component of the photocurrent outputted from the photoelectric conversion element 7a or 7b is smaller than a set value.

As illustrated in Figs. 1 or 2, the signal processing circuit 8 is configured to include the two photoelectric conversion elements 7a or 7b, amplifiers (15a, 15b, and 17), and a current-voltage conversion circuit 16. The configuration of the signal processing circuit 8 and the details on the state of connection between respective elements are illustrated in Fig. 2. As illustrated in Fig. 2, the two photoelectric conversion elements 7a and 7b are connected in series. In addition, the amplifiers 15a or 15b are respectively connected to respective output sides of the photoelectric conversion elements 7a or 7b via respective resistors 18a or 18b. The current-voltage conversion circuit 16 and the amplifier 17 are connected in series to output sides of the photoelectric conversion elements 7a and 7b.

Thus, the signal processing circuit 8 provided in the current measuring device 1 according to the present invention has a configuration with no divider.

The optical signals entering the two photoelectric conversion elements 7a or 7b are converted to a first electric signal (photocurrent) and a second electric signal (photocurrent), respectively. In detail, entry of the optical signals into the two photoelectric conversion elements 7a or 7b causes the photocurrents with alternating current (AC) components superimposed on direct current (DC) components to be outputted from the photoelectric conversion elements 7a or 7b, according to the levels of the incident optical signals.

In the signal processing circuit 8, voltages in proportion to the respective photocurrents are generated at both ends of the resistors 18a or 18b connected to the respective photoelectric conversion elements 7a or 7b, respectively. The voltages are amplified by the amplifiers 15a or 15b, respectively, for output.

The output of the amplifier 15a or 15b is compared with a reference voltage that is not shown. Each of the photo-variable attenuators 6a or 6b is controlled by a drive circuit that is not shown to adjust a quantity of optical attenuation such that the output of the amplifiers 15a or 15b outputs the same voltage as the reference voltage. As a result, the DC components in the photocurrents at the respective photoelectric conversion elements 7a or 7b are controlled so as to be kept constant. By keeping the DC components at the respective photoelectric conversion elements 7a or 7b constant, a variation in optical power of the light source 5 and a difference in optical losses of the polarization splitter 4 and beyond can be compensated.

The middle point between the photoelectric conversion elements 7a and 7b is connected to the current-voltage conversion circuit 16 for inputting of a difference between the first photocurrent and the second photocurrent to the current-voltage conversion circuit 16. The current-voltage conversion circuit 16 converts the difference between the first photocurrent and the second photocurrent to a voltage signal. The voltage signal is further outputted to the amplifier 17 that is a buffer to acquire a voltage signal corresponding to the current to be measured that passes through the conductor 9.

As described above, feeding back of each photocurrent to the photo-variable attenuator 6a or 6b causes the photo-variable attenuator 6a or 6b to adjust the light quantity of the optical signal entering the photoelectric conversion element 7a or 7b when the optical signal subsequently enters the photo-variable attenuator 6a or 6b. The quantity of attenuation by the photo-variable attenuator 6a or 6b according to the feedback signal for each photocurrent is controlled such that the DC components in the first photocurrent and the second photocurrent outputted from the amplifiers 15a or 15b are equal to each other and kept constant.

By keeping the DC components constant, the DC components in the first photocurrent and the second photocurrent are offset for the difference inputted to the current-voltage conversion circuit 16. Meanwhile, the AC components are in opposite phase. A difference is determined in opposite phase. Since the output of the photoelectric conversion element 7a is on the negative side and the output of the photoelectric conversion element 7b is on the positive side, a difference between the AC components is outputted as an output value of the current measuring device 1.

As described above, the current measuring device 1 according to the present invention keeps the DC components in the photocurrents at the respective photoelectric conversion elements 7a or 7b equal and inputs, to the current-voltage conversion circuit 16, the difference between the first photocurrent and the second photocurrent. Thus, no divider is needed in the signal processing circuit 8. Furthermore, removal of in-phase noise (light source noise simultaneously entering the two photoelectric conversion elements 7a and 7b) and output from the current measuring device 1 can be simultaneously achieved.

Furthermore, by offsetting the DC components and inputting only the difference between the AC components to the current-voltage conversion circuit 16, an amplification factor of the current-voltage conversion circuit 16 can be increased. Thus, in association with an increase in the amplification factor of the current-voltage conversion circuit 16, the manufacturing costs can be reduced by reducing the number of amplifiers and the number of components of the signal processing circuit 8. In the present embodiment, the number of amplifiers connected to the current-voltage conversion circuit 16 is reduced to one, the one amplifier being the amplifier 17 constituting a buffer circuit.

Furthermore, band limitations to dividers are removed by using no divider, and thus the band for measurement of the current depends on performance of the current-voltage conversion circuit 16. This enables measurement of the current at a high frequency band (several M(Hz) to several hundred M(Hz)).

Furthermore, the current of devices operating at higher switching frequency can be measured.

Since the number of the current-voltage conversion circuits 16 is limited to one, the impact of the difference in individual current-voltage conversion circuits is removed.

An example according to the present invention will be described below. The present invention, however, is not limited only to the example below.

### Example

The configuration of a current measuring device 1 according to the present example is as illustrated in Figs. 1 and 2. Thus, the components redundant with those in the above-described embodiment are denoted by the same reference numbers and redundant description is omitted or simplified.

A light source 5 of the current measuring device 1 according to the present example is an ASE light source or SLD (both with an oscillation wavelength of 1550 nm). Photoelectric conversion elements (7a and 7b) are InGaAs photodiodes.

A Verdet constant of a sensing optical fiber 2 is 3.75 × 10⁻⁶{rad/(A·turn)}. The number of windings of the sensing optical fiber 2 around the outer periphery of a conductor 9 is ten (turns) and the current to be measured is 1 (A).

Thus, the angle of the Faraday rotation in the sensing optical fiber 2 is 2 × Verdet constant {rad/(A·turn)} × number of windings (turns) ×current to be measured (A) = 2× 3.75 × 10⁻⁶ × 10 × 1 = 7.5 × 10⁻⁵(rad) using a constant of two times because of a reciprocating optical channel with a mirror 10.

The power of an optical signal inputted to each photodiode is 0.526 m (W). The responsivity of the photodiode is 0.95 (AAV). The DC current at the photodiode is 0.5 m (A). The transimpedance at a monitor output of the photodiode is 10 k (V/A).

Thus, the DC components in the photocurrents at the two photodiodes are power of optical signal (W) × responsivity of photodiode (A/W) × transimpedance (V/A), and thus 0.526 m (W) × 0.95 (A/W) × 10k (V/A) ≒ 5 (V) and constant.

Meanwhile, the AC component in the photocurrent at each photodiode is power of inputted optical signal (W) × responsivity of photodiode (A/W) × sin {2 × angle of Faraday rotation (rad) in sensing optical fiber 2} = 0.526 m × 0.95 × sin (2 × 7.5 × 10⁻⁵) = 0.074 µ (A).

From the above, the AC component (V) outputted from the current-voltage conversion circuit 16 is calculated as 2 × 0.074 µ (A) × {transimpedance of 30k (V/A) of current-voltage conversion circuit} = 4.44 m (V).

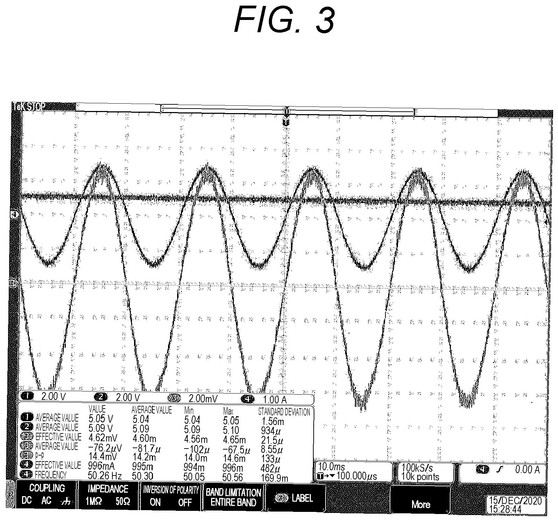

In the actual measurement, an output of 4.6 m (V) was acquired for 1 (A). Fig. 3 illustrates waveforms of output results of the present example measured by an oscilloscope. Ch 1 and Ch 2 are each a monitor voltage signal, Ch 3 is a signal from the current measuring device, and Ch 4 is a value of the current (reference) measured by a current probe.

The current measuring device according to the present example is confirmed to have the same effects as the current measuring device 1 according to the above-described embodiment.

### LIST OF REFERENCE NUMBERS

1 current measuring device
2 sensing optical fiber
2a first end of sensing optical fiber
3 Faraday rotator
4 polarization splitter
5 light source
6a, 6b photo-variable attenuator
7a, 7b photoelectric conversion element
8 signal processing circuit
9 conductor
10 mirror
11a, 11b, 11c, 14a, 14b optical fiber
12a, 12b optical connector
13 optical circulator
15a, 15b, 17 amplifier
16 current-voltage conversion circuit
18a, 18bresistor

## Claims

1. A current measuring device comprising at least: a sensing optical fiber; a light source; two photo-variable attenuators; and a signal processing circuit comprising two photoelectric conversion elements, wherein
the sensing optical fiber is, for placement, wound around an outer periphery of a conductor through which a current to be measured passes,
optical signals emitted from the light source are propagated in the sensing optical fiber, and a Faraday effect caused by the optical signals propagated in the sensing optical fiber rotates polarization planes of the optical signals for measurement of the current to be measured that passes through the conductor,
the signal processing circuit further comprises at least two photoelectric conversion elements and a current-voltage conversion circuit,
the two photoelectric conversion elements are connected in series,
the optical signals enter the photo-variable attenuators and then enter the two photoelectric conversion elements for conversion to a first photocurrent and a second photocurrent,
the first photocurrent or the second photocurrent is fed back to respective photo-variable attenuators to adjust a quantity of light entering the two photoelectric conversion elements and keep DC components in the first photocurrent and the second photocurrent equal to each other, and
a difference between the first photocurrent and the second photocurrent is inputted to the current-voltage conversion circuit for offsetting of the DC components in the first photocurrent and the second photocurrent, and a difference between AC components are outputted to convert the current to be measured that passes through the conductor, to a current signal for measurement.

2. The current measuring device according to claim 1, wherein a number of the current-voltage conversion circuits is one.
